# EUROPEAN PATENT APPLICATION

(11) **EP 2 000 494 A1**
(43) Date of publication of application: **10.12.2008**
(21) Application number: 07380334.8
(22) Date of filing: 29.11.2007
(51) Int. Cl.: C08J 5/10, C08J 5/24, C08J 5/00

(54) **Nanoreinforcement prepreg method and product thus obtained**

(30) Priority: 05.06.2007 ES 200701551
(71) Applicant: Miravete de Marco, Antonio, 50003 Zaragoza (ES); Guzman de Villoria, Roberto, 37003 Salamanca (ES)
(72) Inventor: Miravete de Marco, Antonio, 50003 Zaragoza (ES); Guzman de Villoria, Roberto, 37003 Salamanca (ES)
(74) Representative: Carvajal y Urquijo, Isabel

(57) **Abstract**

The invention relates to a nanoreinforcement prepreg method, comprising at least a first step of mixing the nanoreinforcement with resin and a second step of manufacturing prepregs, in which a product that is easy to apply and with a high storage time is obtained, allowing the easy use of the properties of the nanoreinforcement obtained with the described method.

## Description

### Object of the Invention

The object of this specification is to set forth a new nanoreinforcement prepreg method for nanoreinforcements such as resin films and nanofibers or carbon nanotubes, or any type of nanoreinforcement or nanomaterial, in which a product that is easy to apply and with a high storage time is obtained, allowing the easy use of the properties of the nanoreinforcement obtained with the described method.

### Background of the Invention

Different methods of manufacturing nanoreinforcements are described in the current state of the art, thus patent application WO03040026 describing a method of dispersing carbon nanotubes in polymer matrices appears among the patent documentation. In this case it is not a method of using the nanoreinforcement in a certain manner, but rather the method of manufacturing the actual nanoreinforcement.

Patent application WO 2006/065357 describes a method of making a composite based on the combination of polymers and their chemical treatment.

The inventors, who are persons skilled in the art, do not know any method and product like the one described in this specification.

### Description of the Invention

The method comprises a first step of dispersing the nanoreinforcement with the resin, comprising at least a first step of dispersing in a solvent and a second step of dispersing the nanoreinforcement-solvent blend in the resin.

Once the mixed resin is available, different manufacturing embodiments can be used.

In the first embodiment of the method, the mixed resin is extended between two sheets and the resin is allowed to set for one or two days, such that one sheet can be detached to position the film in the desired place. Pressure can be applied for the purpose of further compacting the resin film or a slight shear can be applied. To control the thickness, the mixture can be leveled with a blade up to the desired thickness. In the event of using solvents to reduce the viscosity of the mixture, they could be completely or partially removed in the resin film manufacturing process by heating the mixture before placing the second protective sheet. Once it is adhered to the surface in which it is to be positioned, the other protective sheet covering the resin film would be removed. Several consecutive sheets can also be adhered for the purpose of making a thicker product.

Once the resin has been mixed with the nanofibers, it is also possible to impregnate a polyester fiber fabric, cellulose fabric, carbon or glass fiber, among others, as in a conventional prepreg process, it being possible in this specific case to detach the two protective sheets before positioning the fabric-nanomaterial-resin film.

The product thus obtained is applicable in monitoring the damage in structures, electrostatic painting, electrostatic shielding, anti-lightning systems in wind generators, surface finishing, wear and structural properties.

The obtained product has a useful life that is not greater than two years at room temperature.

### Preferred Embodiment of the Invention

The nanoreinforcement prepreg method object of the present invention comprises at least:
a first step of mixing the nanoreinforcement with resin, comprising:
   a step of dispersing the nanoreinforcement in a solvent,
   a step of adding nanoreinforcement-solvent to the first component of the resin;
   a step of evaporating the solvent,
   a step of adding the hardener;
a second step of manufacturing a nanoreinforcement mixture prepreg.

The product thus obtained comprises an amount of nanostructures between 0.0001% and 80% by weight. In the same way, its useful shelf life and applicability is less than two years at room temperature, although once the resin has been applied and cured, its operating time is unlimited. The thickness is comprised between 0.05 mm and 2 mm and its density is comprised between 0.5 and 3 g/cm³.

## Claims

1. A nanoreinforcement prepreg method, **characterized in that** it comprises at least:
a first step of mixing the nanoreinforcement with resin, comprising:
a step of dispersing the nanoreinforcement in a solvent,
a step of adding nanoreinforcement-solvent to the first component of the resin;
a step of evaporating the solvent,
a step of adding the hardener;
a second step of manufacturing a nanoreinforcement mixture prepreg.

2. A nanoreinforcement prepreg obtained according to the method of claim 1, **characterized in that** the amount of nanostructures present in the prepreg is comprised between 0.0001 % and 80% by weight.

3. A nanoreinforcement prepreg according to claim 2, **characterized in that** its useful shelf life and applicability is not greater than two years at room temperature.

4. A nanoreinforcement prepreg according to claim 2, **characterized in that** its thickness is comprised between 0.05 mm and 2 mm.

5. A nanoreinforcement prepreg according to claim 2, **characterized in that** its density is comprised between 0.5 and 3 g/cm³.
